# EUROPÄISCHE PATENTSCHRIFT

(11) **EP 2 102 381 B1**
(45) Veröffentlichungstag und Bekanntmachung des Hinweises auf die Patenterteilung: **05.10.2011**
(21) Anmeldenummer: 07856315.2
(22) Anmeldetag: 30.11.2007
(51) Int. Cl.: C23C 14/06, C23C 16/30, C23C 14/22, C23C 16/44, A01N 25/34

(54) **VERFAHREN ZUM HERSTELLEN EINES ANTIMIKROBIELL WIRKENDEN MATERIALS**
METHOD FOR THE PRODUCTION OF AN ANTIMICROBIAL MATERIAL
PROCÉDÉ DE PRÉPARATION D'UNE SUBSTANCE AYANT UNE ACTION ANTIMICROBIENNE

(30) Priorität: 19.12.2006 DE 102006060057
(43) Veröffentlichungstag der Anmeldung: 23.09.2009
(73) Patentinhaber: Fraunhofer-Gesellschaft zur Förderung der angewandten Forschung e.V., 80686 München (DE)
(72) Erfinder: FAHLAND, Matthias, 01259 Dresden (DE); SCHILLER, Nicolas, 01833 Stolpen, OT Helmsdorf (DE); VOGT, Tobias, 02796 Kurort Johnsdorf (DE); FAHLTEICH, John, 01279 Dresden (DE)
(86) Internationale Anmeldenummer: PCT/EP2007/010412
(87) Internationale Veröffentlichungsnummer: WO 2008/074388

(56) Entgegenhaltungen:
- WO-A-2005/049699
- US-A- 5 753 251
- SHANMUGAM ET AL: "A novel single step chemical route for noble metal nanoparticles embedded organic-inorganic composite films" MATERIALS CHEMISTRY AND PHYSICS, ELSEVIER, Bd. 95, Nr. 1, 10. Januar 2006 (2006-01-10), Seiten 51-55, XP005105180 ISSN: 0254-0584

## Beschreibung

Die Erfindung betrifft biozid ein Verfahren zum Herstellen eines wirkenden Materials, welches beispielsweise für reinigende und desinfizierende Zwecke eingesetzt werden kann.

### Stand der Technik

Aus dem Stand der Technik sind eine Vielzahl von Reinigungs- und Desinfektionsmitteln bekannt, die in sehr vielfältiger Form vorliegen können. Insbesondere gibt es eine breite Palette von Tüchern und Vliesen, die mit antimikrobiell wirkenden Materialien belegt sind. Dabei kann deren Wirkmechanismus sehr vielfältig sein. Oftmals werden hierbei chemische Wirkungen spezifischer Moleküle ausgenutzt. Diese haben jedoch den Nachteil, dass sich die antimikrobiell wirksamen Moleküle oft nicht schnell genug mobilisieren lassen. Weiterhin ist von Nachteil, dass diese Moleküle unerwünschte Nebenwirkungen an Umwelt und Personen hervorrufen können, wodurch angemessene Umgangs- und Entsorgungsmaßnahmen erforderlich werden.

Aus diesem Grunde werden sehr oft anorganische Desinfektionsmittel favorisiert, insbesondere Stoffe, die Metallionen, insbesondere Silberionen, abgeben können (US 6,821,936 B2). Antimikrobielle Eigenschaften von Metallen, beispielsweise für Silber, Kupfer oder Zink zur Desinfektion und für den Einsatz in der Reinigungs- und Medizintechnik sind ebenfalls bekannt.

Dabei werden im Wesentlichen zwei Wirkungen unterschieden. In den meisten Fällen ist die biozide Wirkung des Metalls gewünscht. Darunter ist das Abtöten von Mikroorganismen zu verstehen. Im Gegensatz dazu steht die zytotoxische Wirkung, das heißt das Abtöten von biologischem Gewebe, was oftmals eine unerwünschte Wirkung darstellt.

Bei Metallen ist insbesondere das Vorhandensein von Silber in Form von Partikeln mit typischen Abmessungen zwischen 5 nm und 100 nm vorteilhaft für das gewünschte Freisetzen von Metallionen (DE 101 46 050 A1).

Wichtig für eine wirksame Anwendung von Silber ist die Art und Weise der Applikation. In EP 1 644 010 A2 ist eine Flüssigkeit mit antimikrobieller Wirkung beschrieben, die silberhaltige Partikel enthält. In DE 10 2005 020 889 A1 ist ein Gewebe offenbart, das mit silberhaltigen Substanzen behandelt wurde.

Es ist bekannt, dass häufig ein Problem darin besteht, bei einer entsprechenden Applikationszeit die richtige Menge Silber freizusetzen. Bei manchen Anwendungen besteht die Aufgabe darin, dass über eine lange Zeitspanne eine stabile biozide Wirkung erreicht werden soll, wobei zu keinem Zeitpunkt, insbesondere auch nicht nach Beginn einer Applikation, eine zytotoxische Wirkung herbeigeführt werden soll. Eine Lösung für dieses Problem ist in WO 2005/049699 A2 angegeben. Dort ist ein Trägermaterial, zum Beispiel ein Vliesstoff oder ein implantat, beschrieben, das zunächst mit Silber in Form von Partikeln geeigneter Größe beschichtet wird. Anschließend wird diese Silberlage durch eine Transportkontrollschicht abgedeckt, welche die Abgabe des Silbers an die Umgebung für einen längeren Zeitraum regelt. Insbesondere wird durch eine derartige Transportkontrollschicht, durch welche die Silberionen erst hindurch diffundieren müssen, das Freisetzen von zytotoxischen Konzentrationen vermieden. Es sind in dieser Quelle auch verschiedene Methoden beschrieben, diese zwei Lagen auf das Trägermaterial aufzubringen. Unter anderem ist ein Vakuumverfahren offenbart, bei dem das Silber aufgedampft oder gesputtert wird. Anschließend wird eine siliziumhaltige Transportkontrollschicht durch Plasmapolymerisation über der Silberschicht aufgetragen.

Ein Nachteil der in WO 2005/049699 A2 beschriebenen Verfahren besteht darin, dass die Transportkontrollschicht mit einer hohen Präzision abgeschieden werden muss, um die gewünschten Eigenschaften genau einzustellen. Die beschriebenen Vakuumverfahren sind zwar in der Lage, diese Präzision zu erreichen, allerdings erfordert die Verwendung von Geweben als Trägermedium eine separate Abstimmung der beiden Schichten für jedes spezielle Gewebe. Dieser Umstand ist in der mikroskopischen Struktur von Geweben begründet. Das Beschichtungsmaterial dringt während des Beschichtungsvorgangs in das Gewebe ein und scheidet sich auf diese Weise nicht nur auf den äußeren Fasern, sondern auch auf Fasern im Innern des Gewebes ab. Für eine erfolgreiche Regelung bei einem derartigen Beschichtungsvorgang ist die Kenntnis der effektiven Schichtdicke und der effektiven Beschichtungsrate wichtig. Darunter ist die Schichtdicke, beziehungsweise die Beschichtungsrate zu verstehen, die sich bei gleichen Bedingungen auf einem glatten Substrat einstellen würden. Auf Grund der inneren Struktur eines Gewebes sind jedoch die wahren Schichtdicken von Silberschicht und Transportkontrollschicht auf den Fasern, die letztlich über die biozide Wirkung entscheiden, unterschiedlich gegenüber den effektiven Schichtdicken bei glatten Substraten. Ferner weisen die Schichtdicken auf den äußeren Fasern andere Werte auf als die Schichtdicken auf tiefer liegenden Fasern. Damit sind zugleich Grenzen für eine optimale Gestaltung eines in WO 2005/049699 A2 beschriebenen Mehrlagensystems aufgezeigt.

### Aufgabenstellung

Der Erfindung liegt daher das technische Problem zugrunde, ein Verfahren zur Herstellung eines antimikrobiell wirkenden Materials zu schaffen, mit denen die dargestellten Nachteile des Standes der Technik überwunden werden. Insbesondere soll es das Verfahren ermöglichen ein Material herzustellen, welches auf verschiedenen Trägermaterialien abgeschieden weitgehend dieselben bioziden Wirkungen herbeiführt.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Patentansprüchen.

Erfindungsgemäß wird ein antimikrobiell wirkendes Material auf einem Substrat abgeschieden, indem ein zu beschichtendes Substrat in einer Vakuumkammer angeordnet wird, in welcher ein biozid wirkendes Metall mittels einer Sputtereinrichtung bei Anwesenheit eines Inertgases und unter Plasmaeinwirkung zerstäubt wird. Als biozid wirkendes Metall können beispielsweise Kupfer oder Zink verwendet werden. Besonders geeignet ist hierfür Silber. Gleichzeitig wird ein Precursor, welcher Silizium, Kohlenstoff, Wasserstoff und Sauerstoff enthält, wie beispielsweise die Monomere HMDSO (Hexamethydisiloxan) oder TEOS (Tetraethoxysilan), in die Vakuumarbeitskammer eingelassen und dem Plasma ausgesetzt. Aufgrund der Aktivierung des Precursors durch das Plasma und dem gleichzeitigen Zerstäuben des Metalls scheidet sich eine Mischschicht auf dem Substrat ab. Dabei bilden die Bestandteile der Schicht, die aus der Plasmaaktivierung des Precursors hervorgehen, eine Matrix aus, in welcher die zerstäubten Metallteilchen eingelagert sind. Aufgrund des Bestrebens der Metallteilchen zur Agglomeration werden diese in Form kleiner Anhäufungen, nachfolgend auch Cluster genannt, in der Matrix eingelagert. Die Cluster sollten dabei eine Größe von 3 nm bis 40 nm ausbilden. Die biozide Wirkung eines derartigen Materials resultiert aus dem Sachverhalt, dass Metallionen aus den Clustern durch die Matrix diffundieren und an der Oberfläche des Materials angekommen ihre biozide Wirkung entfalten.

Die Matrix erfüllt dabei mehre Aufgaben. Zum einen fixiert die Matrix die Cluster in deren Position innerhalb des Materials, wirkt somit dem Agglomerationsbestreben der Metallteilchen entgegen und behindert dadurch die Vereinigung mehrerer Cluster. Sie hat daher einen entscheidenden Einfluss auf die Größe der sich ausbildenden Cluster. Da Metallionen aus Clustern, die in der Nähe der Oberfläche des Schichtmaterials angeordnet sind, eine kürzere Zeitspanne benötigen, bis diese an die Oberfläche diffundieren als Metallionen aus Clustern, die weiter von der Oberfläche entfernt sind, kann beispielsweise über die Schichtdicke des Materials die Zeitspanne der bioziden Wirkung eingestellt werden.

Des Weiteren werden durch die Eigenschaften der Matrix die Diffusionswege und die Diffusionskoeffizienten der Metallionen innerhalb des Materials bestimmt. So wirken sich beispielsweise auch die Größe der Cluster und die Anzahl der Cluster pro Volumeneinheit auf die Zeit aus, die ein Metallion für das Diffundieren durch eine Schicht bis zur Oberfläche benötigt. Dabei ist diese Zeitspanne umso länger, je größer die Cluster sind und je höher die Konzentration der Cluster ist. Diese Zeitspanne kann aber auch beeinflusst werden, indem zusätzlicher Sauerstoff in die Vakuumarbeitskammer eingelassen wird und dadurch Eigenschaften der Matrix beeinflusst werden. So wirkt sich beispielsweise eine Erhöhung der Sauerstoffkonzentration in der Vakuumarbeitskammer dahingehend aus, dass die Diffusionszeitdauer von Metallionen durch die Matrix verlängert wird.

Dadurch, dass die biozide Wirkung und die Wirkdauer nicht nur über die Schichtdicke einstellbar ist, sondern maßgeblich von den Eigenschaften der Matrix selbst bestimmt wird, in der die Cluster eingelagert sind, lässt sich das erfindungsgemäße Verfahren auch vorteilhaft beim Beschichten von Gewebe einsetzen, ohne bei jeder Gewebeart aufs Neue ein Mehrschichtsystem bezüglich der bioziden Wirkintensität und Wirkdauer einstellen zu müssen. Weiterhin lassen sich auch andere Substratmaterialien wie beispielsweise Vliese oder Kunststofffolien erfindungsgemäß beschichten.

Werden bandförmige Substrate mit einem erfindungsgemäßen Verfahren beschichtet und während des Beschichtens kontinuierlich mit im Wesentlichen konstanter Geschwindigkeit durch die Vakuumarbeitskammer bewegt, wobei die Konzentration der Metallteilchen in der Matrix bereits auf einen gewünschten Wert eingestellt ist, dann kann die Schichtdicke des abzuscheidenden Materials beispielsweise auch mittels der Bandgeschwindigkeit gesteuert werden.

Bei einer Ausführungsform wird die Konzentration der Cluster von der Oberfläche des Schichtmaterials zum Substrat hin mit einem Gradienten ausgebildet. So kann beispielsweise die biozide Wirkung bei einer Applikation mit zunehmender Zeitdauer verstärkt werden, wenn die Konzentration der Cluster zum Substrat hin ansteigend ausgebildet wird und umgekehrt.

Das Zerstäuben des biozid wirkenden Metalls kann beispielsweise mittels eines Singlemagnetrons mit unipolarer Energieeinspeisung durchgeführt werden. Alternativ ist es jedoch auch möglich ein bipolar, mittelfrequent gespeistes Doppelmagnetron dafür zu verwenden. Ein vorteilhafte Ausgestaltung des Verfahrens mit Doppelmagnetron besteht darin, dass ein Magnetron mit einem Target des biozid wirkenden Metalls versehen wird und das andere Magnetron mit einem Target aus Titan. Durch geeignete Einstellungen lässt sich auf diese Weise erreichen, dass noch gezielter auf die Elemente Matrixschicht und Metallcluster Einfluss genommen werden kann. Das lässt sich insbesondere dadurch realisieren, dass die Verteilung der Sputterleistung zwischen den beiden Magnetrons verschieden gestaltet wird. Erhöht man beispielsweise die Leistung des Magnetrons mit dem biozid wirkenden Metall im Vergleich zu dem Titantarget, so steigt der Metallclustergehalt in der Mischschicht. Des Weiteren wirkt sich das zusätzliche Zerstäuben von Titan positiv auf das Ausbilden der Matrix aus, weil bevorzugt auf Titantargets eine Verbindungsschicht durch die Reaktion mit Precursorgasen ausgebildet wird.

Bei einem erfindungsgemäßen Verfahren kann die Schichtdicke und auch die Konzentration der Metallteilchen in der Matrix über die Sputterleistung oder/und die Menge des pro Zeiteinheit in die Vakuumarbeitskammer eingelassenen Precursors oder/und die Menge des pro Zeiteinheit in die Vakuumarbeitskammer eingelassenen Sauerstoffs eingestellt werden.

Eine vorteilhafte Ausgestaltung des Verfahrens besteht darin, die Plasmaemission des Prozesses zu beobachten und an Hand der Auswertung mehrerer Spektrallinien Rückschlüsse auf die Komposition der sich bildenden Mischschicht zu ziehen. Insbesondere bietet sich an, eine Auswertung der Spektrallinie 656 nm für Wasserstoff vorzunehmen, die eine Aussage zur Umsetzung des Precursorgases liefert. Diese Information kann kombiniert werden mit einer Auswertung der Spektrallinie 338 nm, die eine Information zum Silbergehalt im Plasma enthält.

Eine weitere Möglichkeit, Eigenschaften einer abgeschiedenen Schicht zu überwachen bzw. einzustellen, ergibt sich durch eine Steuerung des Abscheideprozesses in Abhängigkeit von einer Auswertung des Reflexionsspektrums eines abgeschiedenen Schichtmaterials. Bei einer Veränderung der zugeführten Sauerstoffmenge in eine Vakuumarbeitskammer bei ansonsten gleich bleibenden Abscheidebedingungen ist eine wahrnehmbare Veränderung des Reflexionsspektrums feststellbar.

Die Erfindung wird nachfolgend anhand eines bevorzugten Ausführungsbeispiels näher erläutert. Die Fig. zeigen:
- Fig. 1: eine schematische Darstellung einer Beschichtungseinrichtung, mit der das erfindungsgemäße Verfahren durchgeführt werden kann,
- Fig. 2: eine graphische Darstellung des Reflexionsspektrums von abgeschiedenen Schichtmaterialien bei zwei unterschiedlichen Sauerstoffzuflussmengen.

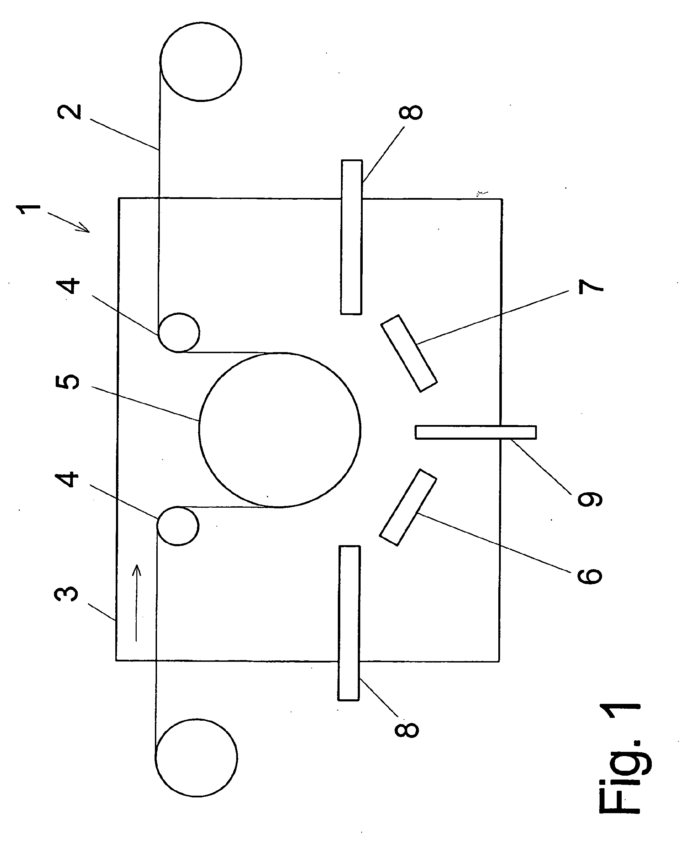

In Fig. 1 ist schematisch eine Beschichtungseinrichtung 1 dargestellt, mittels der ein biozid wirkendes Material auf einem Substrat 2 abgeschieden werden soll. Beschichtungseinrichtung 1 ist als so genannte Rolle-zu-Rolle-Anlage ausgebildet und umfasst eine Vakuumarbeitskammer 3, durch die das Substrat 2 über Umlenkrollen 4 und eine Kühlwalze 5 mit einer weitgehend konstanten Geschwindigkeit von 1 m/min geführt wird. Das bandförmige Substrat 2 ist ein 300 m langes, 600 mm breites und 0,5 mm dickes Gewebe. Die Bewegungsrichtung des Bandes ist durch einen Pfeil angezeigt.

Beschichtungseinrichtung 1 umfasst weiterhin ein Doppelmagnetron mit bipolar gepulster Energieeinspeisung, wobei einem Magnetron ein Silbertarget 6 und dem anderen Magnetron ein Titantarget 7 zugeordnet ist. Zwischen den Targets 6 und 7, von denen abwechselnd eines als Anode und das andere als Kathode fungiert, wird während des Sputterns ein Plasma ausgebildet.

Über Zuleitungen 8 wird ein Gasgemisch aus dem Inertgas Argon und dem Reaktivgas Sauerstoff in die Vakuumarbeitskammer 3 eingelassen, wobei sowohl Argon als auch Sauerstoff mit jeweils 150 sccm in die Vakuumarbeitskammer 3 strömen. Ebenfalls gleichzeitig zum Sputtervorgang wird über eine Zuleitung 9 das Monomer HMDSO in die Vakuumarbeitskammer 3 eingelassen, welches durch das dort vorhandene Plasma aktiviert wird.

In das Doppelmagnetron wird insgesamt eine Leistung von 12 kW eingespeist, wobei das Magnetron, welches dem Titantarget 7 zugeordnet ist, mit 60 % der Gesamtleistung beaufschlagt wird.

Unter den angegebenen Bedingungen wird das Silbertarget 6 sehr gut zerstäubt, wohingegen sich auf dem Titantarget 7 eine Verbindungsschicht ausbildet, die einerseits aus durch das Plasma aktivierten Bestandteilen des Monomers und andererseits aus Reaktionsprodukten des Titans mit Sauerstoff besteht.

Sowohl die durch das Plasma aktivierten Bestandteile des Monomers als auch die vom Titantarget abgestäubten Teilchen der darauf entstehenden Verbindungsschicht bilden auf dem Substrat 2 eine Matrix aus, in der vom Silbertarget abgestäubte Teilchen in Form von Clustern eingelagert sind. Die Cluster sind mit einer Größe von etwa 10 nm ausgebildet und das auf dem Substrat abgeschiedene Material weist eine Schichtdicke von 100 nm auf, wobei die Bestandteile Silber und Silizium in einem Verhältnis von 1:1 im Schichtmaterial vorliegen.

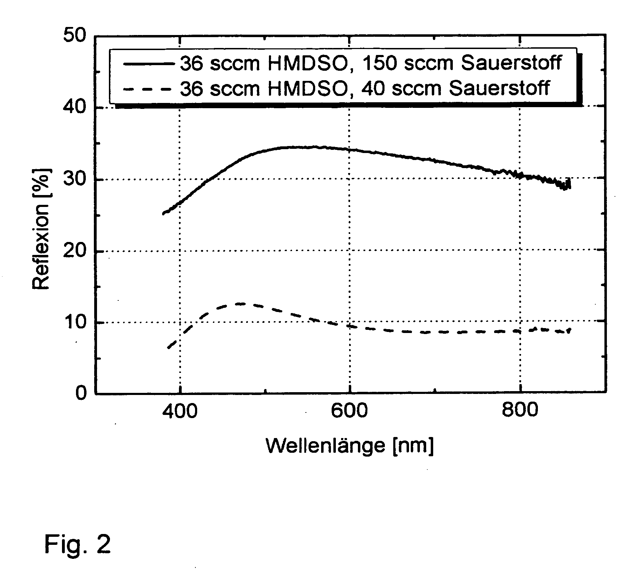

In Fig. 2 ist die Abhängigkeit von Reflexionseigenschaften eines abgeschiedenen Schichtmaterials von der Sauerstoffzuflussmenge in eine Vakuumarbeitskammer graphisch veranschaulicht. Der Versuchsaufbau wurde hierbei mit den gleichen Parametern wie in der Beispielsbeschreibung von Fig. 1 durchgeführt. Bei einer ersten Probebeschichtung wurde die Sauerstoffzuflussmenge auf 150 sccm eingestellt und bei einer zweiten Probebeschichtung auf 40 sccm. Aus Fig. 2 ist erkennbar, dass bei den Reflexionsspektren, die während der beiden Probebeschichtungen erfasst wurden, deutlich wahrnehmbare Unterschiede im Reflexionsverhalten des abgeschiedenen Schichtmaterials festgestellt werden konnten. Das Erfassen von Reflexionseigenschaften des abgeschiedenen Schichtmaterials bietet daher eine gute Möglichkeit, Werte zu erfassen, in deren Abhängigkeit Eigenschaften eines abgeschiedenen Schichtmaterials überprüft bzw. eingestellt werden können. Welche Auswirkungen das Verändern des Sauerstoffzuflusses auf Eigenschaften des Schichtmaterials hat, wurde bereits oben beschrieben.

## Patentansprüche

1. Verfahren zum Herstellen eines biozid wirkenden Materials, welches auf einem Substrat abgeschieden wird, umfassend die Schritte:
a) Bereitstellen des Substrates in einer Vakuumarbeitskammer,
b) Zerstäuben eines biozid wirkenden Metalls mittels einer Sputtereinrichtung innerhalb der Vakuumarbeitskammer unter Anwesenheit eines Inertgases,
c) gleichzeitiges Einlassen eines Precursors, der Silizium, Kohlenstoff, Wasserstoff und Sauerstoff enthält, in die Vakuumarbeitskammer, so dass die abgestäubten Metallteilchen und der Precursor einer Plasmaeinwirkung ausgesetzt werden,
d) Abscheiden eines Materials auf dem Substrat derart, dass durch die Plasmaaktivierung des Precursors eine Matrix entsteht, in welche Cluster von abgestäubten Metallteilchen eingelagert werden.

2. Verfahren nach Anspruch 1, **dadurch gekennzeichnet, dass** Silber oder Kupfer oder Zink als biozid wirkendes Metall verwendet wird.

3. Verfahren nach Anspruch 1 oder 2, **dadurch gekennzeichnet, dass** HMDSO oder TEOS als Precursor verwendet wird.

4. Verfahren nach einem der vorhergehenden Ansprüche, **dadurch gekennzeichnet, dass** Sauerstoff in die Vakuumarbeitskammer eingelassen wird.

5. Verfahren nach einem der vorhergehenden Ansprüche, **dadurch gekennzeichnet, dass** die Konzentration der Metallteilchen in der Matrix über die Sputterleistung oder/und die Menge des pro Zeiteinheit in die Vakuumarbeitskammer eingelassenen Precursors oder/und die Menge des pro Zeiteinheit in die Vakuumarbeitskammer eingelassenen Sauerstoffs eingestellt wird.

6. Verfahren nach einem der vorhergehenden Ansprüche, **dadurch gekennzeichnet, dass** die Konzentration der Metallteilchen in der Matrix mit einem Gradienten zum Substrat hin derart ausgebildet wird, dass die Konzentration der Metallteilchen in Richtung Substrat ab- oder zunimmt.

7. Verfahren nach einem der vorhergehenden Ansprüche, **dadurch gekennzeichnet, dass** die Schichtdicke des Materials über die Sputterleistung oder/und die Menge des pro Zeiteinheit in die Vakuumarbeitskammer eingelassenen Precursors oder/und die Menge des pro Zeiteinheit in die Vakuumarbeitskammer eingelassenen Sauerstoffs eingestellt wird.

8. Verfahren nach einem der vorhergehenden Ansprüche, **dadurch gekennzeichnet, dass** ein Gewebe oder ein Vlies oder eine Kunststofffolie als Substrat verwendet wird.

9. Verfahren nach einem der vorhergehenden Ansprüche, **dadurch gekennzeichnet, dass** ein bandförmiges Substrat verwendet wird und während des Beschichtens kontinuierlich mit im Wesentlichen konstanter Geschwindigkeit durch die Vakuumarbeitskammer bewegt wird.

10. Verfahren nach Anspruch 9, **dadurch gekennzeichnet, dass** bei einer vorgegebenen und bereits eingestellten Konzentration der Metallteilchen in der Matrix die Schichtdicke über die Bandgeschwindigkeit des Substrates eingestellt wird.

11. Verfahren nach einem der Ansprüche 1 bis 10, **dadurch gekennzeichnet, dass** ein Einzelmagnetron mit unipolar gepulster Energieeinspeisung als Sputtereinrichtung verwendet wird.

12. Verfahren nach einem der Ansprüche 1 bis 10, **dadurch gekennzeichnet, dass** ein Doppelmagnetron mit bipolar gepulster, mittelfrequenter Energieeinspeisung als Sputtereinrichtung verwendet wird.

13. Verfahren nach Anspruch 12, **dadurch gekennzeichnet, dass** ein Target aus dem biozid wirkenden Metall und ein Target aus einem weiteren Material verwendet werden.

14. Verfahren nach einem der vorhergehenden Ansprüche, **dadurch gekennzeichnet, dass** die Cluster mit einer Größe von 3 nm bis 40 nm ausgebildet werden.

15. Verfahren nach Anspruch 13, **dadurch gekennzeichnet, dass** Titan als weiteres Material verwendet wird.

## Claims

1. Process for producing a biocidally active material which is deposited on a substrate, comprising the steps:
a) provision of the substrate in a vacuum chamber,
b) atomization of a biocidally active metal by means of a sputtering device within the vacuum chamber in the presence of an inert gas,
c) simultaneous introduction of a precursor containing silicon, carbon, hydrogen and oxygen into the vacuum chamber so that the atomized metal particles and the precursor are exposed to the action of a plasma,
d) deposition of a material on the substrate in such a way that the plasma activation of the precursor forms a matrix in which clusters of atomized metal particles are embedded.

2. Process according to Claim 1, **characterized in that** silver or copper or zinc is used as biocidally active metal.

3. Process according to Claim 1 or 2, **characterized in that** HMDSO or TEOS is used as precursor.

4. Process according to any of the preceding claims, **characterized in that** oxygen is introduced into the vacuum chamber.

5. Process according to any of the preceding claims, **characterized in that** the concentration of the metal particles in the matrix is set via the sputtering power or/and the amount of precursor introduced per unit time into the vacuum chamber or/and the amount of oxygen introduced per unit time into the vacuum chamber.

6. Process according to any of the preceding claims, wherein the concentration of the metal particles in the matrix is given a gradient in the direction of the substrate in such a way that the concentration of the metal particles decreases or increases in the direction of the substrate.

7. Process according to any of the preceding claims, **characterized in that** the layer thickness of the material is set via the sputtering power or/and the amount of precursor introduced per unit time into the vacuum chamber or/and the amount of oxygen introduced per unit time into the vacuum chamber.

8. Process according to any of the preceding claims, **characterized in that** a woven fabric or a nonwoven or a polymer film is used as substrate.

9. Process according to any of the preceding claims, **characterized in that** a tape-like substrate is used and is moved continuously through the vacuum chamber at an essentially constant velocity during coating.

10. Process according to Claim 9, **characterized in that** the layer thickness is set via the tape velocity of the substrate at a prescribed and previously set concentration of the metal particles in the matrix.

11. Process according to any of Claims 1 to 10, **characterized in that** a single magnetron having unipolar pulsed energy input is used as sputtering device.

12. Process according to any of Claims 1 to 10, **characterized in that** a double magnetron having bipolar pulsed, medium-frequency energy input is used as sputtering device.

13. Process according to Claim 12, wherein a target made of the biocidally active metal and a target made of a further material are used.

14. Process according to any of the preceding claims, **characterized in that** the clusters formed have a size of from 3 nm to 40 nm.

15. Process according to Claim 13, **characterized in that** titanium is used as further material.

## Revendications

1. Procédé de préparation d'une substance ayant une action biocide, qui est déposée sur un substrat, comprenant les étapes suivantes:
a) préparer le substrat dans une chambre de travail sous vide;
b) pulvériser un métal ayant une action biocide au moyen d'un dispositif de pulvérisation à l'intérieur de la chambre de travail sous vide en présence d'un gaz inerte;
c) introduire simultanément un précurseur, qui contient du silicium, du carbone, de l'hydrogène et de l'oxygène, dans la chambre de travail sous vide, de telle manière que les particules de métal pulvérisées et le précurseur soient exposés à l'action d'un plasma;
d) dépôt d'une substance sur le substrat de telle manière que, par l'activation au plasma du précurseur, il apparaisse une matrice dans laquelle des amas de particules de métal pulvérisées sont incluses.

2. Procédé selon la revendication 1, **caractérisé en ce que** l'on utilise l'argent ou le cuivre ou le zinc comme métal ayant une action biocide.

3. Procédé selon la revendication 1 ou 2, **caractérisé en ce que** l'on utilise du HMDSO ou du TEOS comme précurseur.

4. Procédé selon l'une quelconque des revendications précédentes, **caractérisé en ce que** l'on introduit de l'oxygène dans la chambre de travail sous vide.

5. Procédé selon l'une quelconque des revendications précédentes, **caractérisé en ce que** l'on règle la concentration des particules de métal dans la matrice au moyen de la puissance de pulvérisation et/ou la quantité de précurseur introduite dans la chambre de travail sous vide par unité de temps et/ou la quantité d'oxygène introduite dans la chambre de travail sous vide par unité de temps.

6. Procédé selon l'une quelconque des revendications précédentes, **caractérisé en ce que** l'on réalise la concentration des particules de métal dans la matrice avec un gradient en direction du substrat, de telle manière que la concentration des particules de métal diminue ou augmente en direction du substrat.

7. Procédé selon l'une quelconque des revendications précédentes, **caractérisé en ce que** l'on règle l'épaisseur de couche de la substance au moyen de la puissance de pulvérisation et/ou la quantité de précurseur introduite dans la chambre de travail sous vide par unité de temps et/ou la quantité d'oxygène introduite dans la chambre de travail sous vide par unité de temps.

8. Procédé selon l'une quelconque des revendications précédentes, **caractérisé en ce que** l'on utilise comme substrat un tissu ou une toile ou un film de matière plastique.

9. Procédé selon l'une quelconque des revendications précédentes, **caractérisé en ce que** l'on utilise un substrat en forme de bande et on le déplace en continu à travers la chambre de travail sous vide avec une vitesse essentiellement constante pendant le revêtement.

10. Procédé selon la revendication 9, **caractérisé en ce que**, avec une concentration prédéterminée et déjà réglée des particules de métal dans la matrice, on règle l'épaisseur de couche au moyen de la vitesse de bande du substrat.

11. Procédé selon l'une quelconque des revendications 1 à 10, **caractérisé en ce que** l'on utilise un magnétron unique avec une alimentation en énergie à pulsation unipolaire comme dispositif de pulvérisation.

12. Procédé selon l'une quelconque des revendications 1 à 10, **caractérisé en ce que** l'on utilise un magnétron double avec une alimentation en énergie à moyenne fréquence à pulsation bipolaire comme dispositif de pulvérisation.

13. Procédé selon la revendication 12, **caractérisé en ce que** l'on utilise une cible composée du métal ayant une action biocide et une cible composée d'une autre substance.

14. Procédé selon l'une quelconque des revendications précédentes, **caractérisé en ce que** les amas sont formés avec une taille de 3 nm à 40 nm.

15. Procédé selon la revendication 13, **caractérisé en ce que** l'on utilise le titane comme autre substance.
